# EUROPÄISCHE PATENTSCHRIFT

(11) **EP 2 073 321 B1**
(45) Veröffentlichungstag und Bekanntmachung des Hinweises auf die Patenterteilung: **24.08.2016**
(21) Anmeldenummer: 08021988.4
(22) Anmeldetag: 18.12.2008
(51) Int. Cl.: H01R 24/78

(54) **Installationsgerät**
Installation device
Appareil d'installation

(30) Priorität: 21.12.2007 DE 102007063591
(43) Veröffentlichungstag der Anmeldung: 24.06.2009
(73) Patentinhaber: Merten GmbH, 51674 Wiehl (DE)
(72) Erfinder: Vicktorius, Richard, 50733 Köln (DE)

(56) Entgegenhaltungen:
- EP-A2- 0 281 969
- EP-A2- 0 802 465
- WO-A1-2007/027063
- US-A1- 2003 050 737

## Beschreibung

Die Erfindung betrifft ein Installationsgerät für die Gebäudesystemtechnik nach dem Oberbegriff des Patentanspruches 1.

Elektrische Installationsgeräte werden im Rahmen der Gebäudesystemtechnik sowohl bei der Erstausstattung als auch im Nachrüstbereich eingesetzt. Häufig ist es wichtig, das jeweilige elektrische Installationsgerät funktional aufrüsten zu können. Aus diesem Grund hat es sich als vorteilhaft erwiesen, modulare Baugruppen zu schaffen, mit denen bei Bedarf das vorhandene Gerät ergänzt werden kann. Aus dem Stand der Technik, beispielsweise aus der EP 0 281 969 B1, ist ein netzversorgtes Installationsgerät bekannt, bei dem eine Baugruppe rückseitig befestigt werden kann, die in Form eines Überspannungsschutzes funktional auf das Installationsgerät einwirkt.

Das Dokument US2003/0050737 offenbart ein Gerät gemäss dem Oberbegriff des Anspruchs 1.

Neben herkömmlichen leitungsgebundenen Installationssystemen existieren Systeme bei denen Datentelegramme drahtlos mittels Funksignalen von Bedienelementen und Sensoren zur lastschaltenden Aktorik übertragen werden, die dann leitungsgebunden die jeweiligen Verbraucher mit Netzspannung versorgt.

Zur Ermittlung von Verbrauchsdaten eines angeschlossenen Verbrauchers sind spezielle Geräte bekannt, die zwischen Verbraucher und Steckdose geschaltet werden. Nachteilig ist dabei, dass mit derartigen dezentralen Messstellen eine raum- oder gebäudebezogene Erfassung von Daten äußerst aufwendig ist.

Die Aufgabe der vorliegenden Erfindung besteht deshalb darin, die vorstehend genannten Nachteile zu beseitigen und ein Installationsgerät einschließlich eines Gerätesystems zu schaffen, das eine komfortable Erfassung und Regelung von Nutzungsdaten ermöglicht.

Gelöst wird diese Aufgabe durch die im Patentanspruch 1 angegebenen Merkmale. Vorteilhafte Ausgestaltungen ergeben sich aus den Unteransprüchen.

Die Erfindung gemäß dem Patentanspruch 1 weist den Vorteil auf, dass durch den Anschluss eines drahtlos kommunizierenden Moduls ortsfeste und spannungsversorgende Installationsgeräte bei Bedarf so aufgerüstet werden können, dass ein Datenaustausch mit Teilnehmern eines drahtlosen Teilsystems ermöglicht wird und spezifische elektrische Parameter einzelner Verbraucher an einem Gerät zusammengefasst ausgewertet und geregelt werden können.

Dieses Gerät ist vorteilhafterweise an einer zentralen und gut zugänglichen Stelle montiert und mit einer Anzeigeeinheit, beispielsweise einem Display, und Bedienelementen ausgestattet. Dabei existieren verschiedene Anzeigemodi, um die Verbraucherdaten zu visualisieren. Eine besonders vorteilhafte Ausführung ergibt sich durch eine zusammengefasste Darstellung der Daten einzelner Verbraucher, so dass beispielsweise raum- oder gebäudebezogene Nutzungskonzepte möglich sind.

Die Bedienelemente ermöglichen des weiteren eine fernbedienbare Regelung der Parameter einzelner Verbraucher, um ein spezifisches Verbraucherverhalten zu definieren, indem beispielsweise größen- oder zeitabhängige Schwellwerte vorgegeben werden, bei denen bestimmte Visualisierungen aktiviert werden oder der Verbraucher abgeschaltet wird.

Die Eingaben und die verbraucherspezifischen Werte werden in ein Datentelegramm umgesetzt und drahtlos zu dem Modul übertragen. So kann auch auf wechselnde Verbraucher an den Verbrauchsstellen reagiert werden, indem verbraucherspezifische Einstellungen vordefiniert abgespeichert werden.

Neben der reinen Parametererfassung ist eine Abschaltung des Verbrauchers durch schaltende Bauelemente, vorzugsweise Relais, möglich. Darüber hinaus ist auch eine Zustandserkennung des Verbrauchers möglich, so dass zwischen eingeschaltetem oder ausgeschaltetem Verbraucher unterschieden werden kann, einschließlich einer Detektierung defekter Verbraucher durch Auswertung des hin- und rückfließenden Stromes.

Durch die vorstehenden Regelungsmöglichkeiten einzelner Verbrauchsstellen und der Datenzusammenführung in einem Gerät lassen sich verbrauchsabhängige Nutzungskonzepte realisieren. Verbrauchsabhängig können beispielsweise farblich unterschiedliche Signale erzeugt werden oder direkt die Verbrauchskosten angezeigt werden, sowie eine zeit- und/oder größenabhängige Abschaltung von Verbrauchern.

Spezifische Parameter von elektrischen Verbrauchern sind der elektrische Strom und die elektrische Leistung, so dass bevorzugt diese elektrischen Größen durch geeignete mess- und schalttechnische Bauelemente in dem Modul ermittelt und geregelt wird. Eine besonders vorteilhafte Methode zur Strommessung erfolgt mittels berührungslos wirkender Hall-Sensoren. Eine Abschaltung des Stromes geschieht durch elektronische Relais. Des weiteren sind Verarbeitungsbausteine für die erfassten Parameter und die Modulation/Demodulation der Daten in Funksignale in dem Modul integriert. Mit einer Programmlogik können Schwellwerte definiert werden, bei denen das Modul beispielsweise den Stromfluss zum Verbraucher unterbricht. Hierzu sind sowohl in dem Modul als auch in den drahtlos kommunizierenden Geräten entsprechende, vorzugsweise programmierbare, Bauelemente vorhanden.

Bevorzugterweise werden zur drahtlosen Übermittlung der Daten zwischen dem Modul und den weiteren Geräten Funksignale benutzt, da im Rahmen einer Gebäudeinstallation eine weitgehend sichere Übertragung gewährleistet ist. Da die zu adaptierenden Geräte funktional in sich geschlossene Baugruppen bilden, sind am Installationsgerät keine Veränderungen notwendig. In Funk basierenden Modulen wird eine eingehende Netzspannung in eine geeignete kleinere Spannung und/oder andere Energieart für die Funkbauelemente umgewandelt. Optional sind visuell oder akustisch wirkende Bauelemente beispielsweise für Zustandsmeldungen angeordnet.

In der Regel lässt sich die Adaption von derartigen drahtlos kommunizierenden Modulen bei netzversorgten Installationsgeräte, vorzugsweise Steckdosen, anwenden. Denkbar ist jedoch auch die Verwendung bei jedem anderen lastlastenden Aktor, wie beispielsweise einem separaten Schaltaktor in einer festverdrahteten Lampe. Vorteilhafterweise wird durch die erfindungsgemäße Anordnung mit geringem Installationsaufwand eine verdeckte Installation und Aufrüstung bestehender Installationsgeräte möglich. Darüber hinaus wird eine permanente Spannungsversorgung ermöglicht, so dass auf temporäre Energiespeicher verzichtet werden kann.

Die erfindungsgemäße Anordnung kann sowohl in Aufputz- als auch in Unterputzinstallationen realisiert werden. Eine Adaption an vorhandene Installationsgeräte ist unproblematisch, da an den Anschlussklemmen ein zusätzlicher Abgriff jederzeit möglich ist.

Die Anordnung des Gerätes erfolgt in einer Ausführung rückseitig des drahtgebundenen Installationsgerätes, da hier ausreichend Montageplatz vorhanden ist. Installationstechnisch ist dabei die Verwendung einer tiefen Installationsdose vorteilhaft, da dann eine leichte Montage möglich ist.

In bevorzugt ausgebildeten Installationsgeräten ist eine platzsparende Anordnung des drahtlos arbeitenden Gerätes möglich. Dabei wird durch eine vorteilhafte Bauteilanordnung innerhalb der vorhandenen Struktur des Gerätesockels ein Aufnahmeraum geschaffen, so dass das Gerät vorzugsweise formschlüssig und flächenbündig in den Gerätesockel integriert werden kann. Es wird kein zusätzlicher Platz vor oder hinter dem Gerätesockel benötigt, um das Gerät anzuordnen. Somit wird ein universell verwendbares Installationsgerät geschaffen, das im Bedarfsfall mit einem geeigneten Gerät kombiniert werden kann. Die allgemein vorhandene Struktur von Gerätesockeln, insbesondere deren Abmessungen und deren Befestigungs- und Kontaktpunkte, bleibt unverändert erhalten.

Besonders vorteilhaft ist dabei die Ausbildung eines frontseitig zugänglichen Aufnahmeraumes innerhalb des Gerätesockels, da der Gerätesockel für die Montage dann nicht aus dem Installationsgehäuse gelöst werden muss. Lediglich das entsprechende Frontelement muss entfernt werden, um das Gerät einsetzen zu können. Es entsteht ein erheblicher Installationsvorteil. Darüber hinaus können funktionsspezifischen Frontelemente innerhalb einer Produktserie beim Austausch eines bestehenden Installationsgerätes weiter verwendet werden.

Der elektrische Anschluss des Gerätes erfolgt indirekt an der Versorgungsspannung des Installationsgerätes, vorteilhafterweise mit einer lösbaren Technik, insbesondere mittels Steckung, an die Anschlussklemmen oder Kontaktelemente des Installationsgerätes. Die Kontaktierung des Gerätes erfolgt vorteilhafterweise während der Gerätemontage selbsttätig. Die entsprechenden Kontaktelemente des Installationsgerätes und des zu adaptierenden Gerätes sind berührungsgeschützt angeordnet. Denkbar ist jedoch auch eine unlösbare Verbindung.

Eine mögliche Ausführungsform der Erfindung ergibt sich durch eine elektrische Steckdose mit einem rückseitig des Gerätesockels angeordneten und über Anschlussklemmen des Gerätesockels mit der Netzspannung versorgten Modul.

Weitere Einzelheiten, Merkmale und Vorteile der Erfindung ergeben sich aus nachfolgender Beschreibung eines bevorzugten Ausführungsbeispieles anhand der Zeichnungen.

Es zeigen:

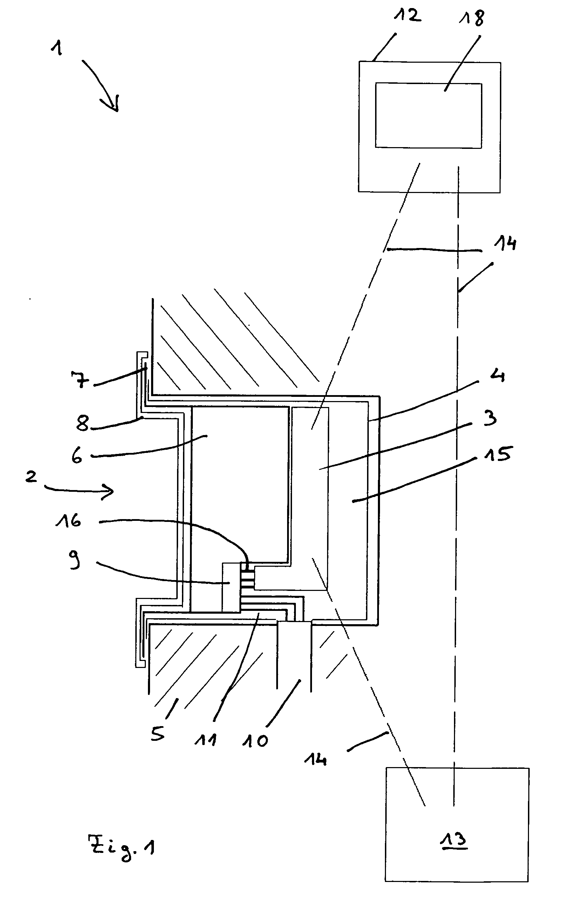

- Figur 1: schematisch eine erfindungsgemäße Geräteanordnung mit einem Installationsgerät mit rückseitiger Modulanordnung.
- Figur 2: ein weiteres Ausführungsbeispiel mit rückseitiger Modulanordnung.
- Figur 3: ein weiteres Ausführungsbeispiel mit frontseitiger Modulanordnung.

Gleiche oder gleichwirkende Bauteile sind in der nachfolgenden Beschreibung mit gleichen Bezugszeichen versehen.

Nachfolgend wird der Aufbau und die Funktionsweise der Erfindung anhand einer Geräteanordnung 1 schematisch an drei Alternativen näher beschrieben. Beispielhaft ist dabei ein erstes elektrisches Gerät 2 in Form einer Steckdose dargestellt, die mit einem drahtlos kommunizierenden Modul 3 bestückt ist, wobei die Datenübertragung mittels Funksignalen 14 erfolgt.

Die Geräteanordnung 1 weist ein erstes elektrisches Gerät 2 auf, das in einem Installationsgehäuse 4 befestigt ist, welches ortsfest in einer Gebäudewand 5 fixiert ist. Das Gerät 2 weist einen Gerätesockel 6 auf, den außenseitig ein Tragrahmen 7 umgibt, der die Befestigung des Gerätes 2 in dem Installationsgehäuse 4 ermöglicht. Frontseitig ist ein funktionsspezifisches Frontelement 8 befestigt, das je nach Anwendung ein- oder mehrteilig sein kann. In dem Gerätesockel 6 sind Anschlussklemmen 9 und damit verbundene metallische Kontaktelemente angeordnet, in die frontseitig Steckerstifte eines nicht dargestellten Gerätesteckers gesteckt werden. Des weiteren ist in dem Gerätesockel 6 ein Erdungsbügel angeordnet, der zur frontseitigen Kontaktierung eines Erdungskontaktes des Gerätesteckers dient. Eine wandseitig verlegte Versorgungsleitung 10 versorgt das Gerät 2 mit einer Netzspannung, wobei die einzelnen Leitungen 11 lösbar in den Anschlussklemmen 9 fixiert sind.

Darüber hinaus ist schematisch ein funkbasierendes Teilsystem dargestellt, zu dem neben Geräten 12 und 13 auch das Modul 3 gehört, zwischen denen mittels Funksignalen 14 Datentelegramme ausgetauscht werden. Das Datentelegramm enthält u. a. Parameter des an dem Gerät 2 angeschlossenen Verbrauchers. In dem Modul 3 sind mess- und schalttechnische Bauelemente angeordnet, die eine Strom- und/oder Leistungsmessung sowie eine Abschaltung des über das Gerät 2 fließenden Stromes für den angeschlossenen Verbraucher ermöglichen, z. B. Hallsensoren und Relais. Des weiteren sind Verarbeitungsbaustein für die erfassten Parameter und die Modulation/Demodulation der Daten in Funksignale integriert. In dem Gerät 12 werden die Daten des Moduls 3 und des Gerätes 13 ausgewertet und über eine Bedien- und Anzeigeeinheit 18 visualisiert. Mit einer Programmlogik können zeit- und/oder größenabhängige Schwellwerte definiert werden, bei denen einerseits bestimmte Anzeigeoptionen aktiviert werden und andererseits das Modul 3 den Stromfluss zum Verbraucher unterbricht. Hierzu sind sowohl in dem Modul 3 als auch in dem Gerät 12 entsprechende, vorzugsweise programmierbare, Bauelemente vorhanden.

Das Gerät 3 ist in einem Freiraum 15 in dem Installationsgehäuse 4 hinter dem Gerät 2 angeordnet. Das Gerät 3 ist über Anschlusskontakte 16 lösbar mit den Anschlussklemmen 9 des Installationsgerätes 2 verbunden und somit ebenfalls an das Versorgungsnetz angeschlossen. In dem Gerät 3 sind diverse elektronische Bauteile angeordnet, mit denen eine Transformation der eingehenden Netzspannung in eine geeignete Versorgungsspannung für die Funkbauelemente realisiert wird. Durch die Anordnung an dem Installationsgerät 2 kann die entsprechende Leitungsinstallation und die Netzspannung mitgenutzt werden und separate Installationsarbeiten entfallen. Außerdem sind im sichtbaren Bereich der Geräte 2 keine vorstehenden und optisch nachteiligen Zusatzgeräte notwendig.

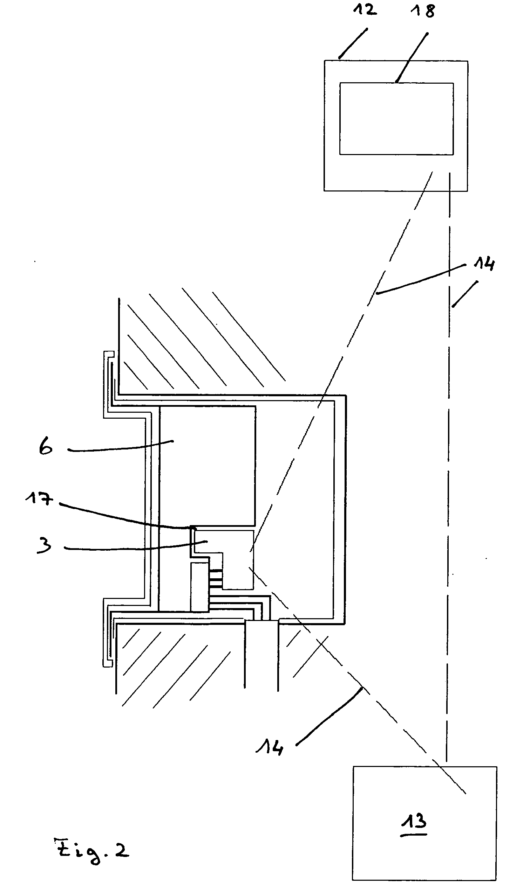

Gemäß Figur 2 ist eine vorteilhafte rückseitige Anordnung des Gerätes 3 innerhalb eines Aufnahmeraumes 17 in dem Gerätesockel 6 dargestellt. Im unbestückten Zustand verschließt eine entfernbare Abdeckung (nicht dargestellt) diesen Aufnahmeraum 17, in den das Gerät 3 formschlüssig einsetzbar und rastend fixierbar ist. Bodenseitig sind die Anschlusskontakte 16 berührungsgeschützt aus dem Gerät 3 geführt, die mit den Anschlussklemmen 9 in dem Gerätesockel 6 elektrisch kontaktierbar sind. Für die Montage des Gerätes 3 wird das Frontelement 8 entfernt, der Gerätesockel 6 aus dem Installationsgehäuse 4 gelöst und anschließend die Abdeckung des Aufnahmeraumes 17 entfernt. Das Gerät 3 wird in den Aufnahmeraum 17 geschoben. Automatisch wird es dabei sowohl mechanisch verrastet als auch elektrisch an die Netzspannung angeschlossen. Abschließend wird der so bestückte Gerätesockel 6 wieder in dem Installationsgehäuse 4 befestigt und das Frontelement 8 montiert.

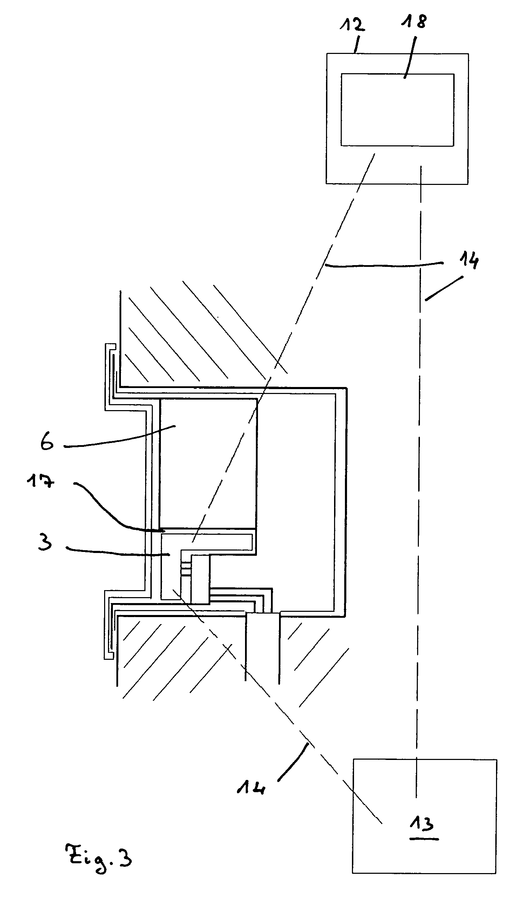

Gemäß Figur 3 ist eine vorteilhafte frontseitige Anordnung des Gerätes 3 in einem Aufnahmeraum 17 des Gerätesockels 6 dargestellt. Im unbestückten Zustand verschließt eine entfernbare Abdeckung (nicht dargestellt) diesen Aufnahmeraum 17, in den das Gerät 3 formschlüssig einsetzbar und rastend fixierbar ist. Bodenseitig sind die Anschlusskontakte 16 berührungsgeschützt aus dem Gerät 3 geführt, die mit den Anschlussklemmen 9 in dem Gerätesockel 6 elektrisch kontaktierbar sind.

Für die Montage des Gerätes 3 wird das Frontelement 8 und anschließend die Abdeckung des Aufnahmeraumes 17 entfernt. Aufgrund des Formschlusses und einer zylindrischen Raumerstreckung kann das Gerät 3 ohne Verkantungen linear bis zum Anschlag in den kreissegmentförmigen Aufnahmeraum 17 geschoben werden. Automatisch wird es dabei sowohl mechanisch verrastet als auch elektrisch an die Netzspannung angeschlossen. Oberseitig des Gerätes 3 befinden sich Leuchtelemente, um Lichtsignale gezielt an Anzeigeelemente in dem Frontelement 8 leiten zu können. Abschließend wird das Frontelement 8 wieder montiert. In diesem Ausführungsbeispiel ist weder ein Ausbau des Installationsgerätes 2 noch sind zusätzliche Anschlussarbeiten notwendig.

### Bezugszeichenliste

- 1: Geräteanordnung
- 2: Erstes Gerät
- 3: Modul
- 4: Installationsgehäuse
- 5: Gebäudewand
- 6: Gerätesockel
- 7: Tragrahmen
- 8: Frontelement
- 9: Anschlussklemmen
- 10: Versorgungsleitung
- 11: Leitungen
- 12: Gerät
- 13: Gerät
- 14: Funksignal
- 15: Freiraum
- 16: Anschlusskontakte
- 17: Aufnahmeraum
- 18: Bedien- und Anzeigeeinheit

## Patentansprüche

1. Installationsgerät für die Gebäudesystemtechnik, das einen Gerätesockel (6) aufweist, der ortsfest in einem Installationsgehäuse (4) befestigt ist, der an eine Netzspannung angeschlossen ist, und an dem frontseitig ein Frontelement (8) befestigt ist, **dadurch gekennzeichnet, dass** *in dem Installationsgehäuse (4)* an dem Gerätesockel (6) ein entfernbares Modul (3) angeordnet ist, mit dem elektrische Parameter in dem Gerät (2) erfassbar und/oder regelbar sind und das drahtlos kommuniziert, *wobei Verarbeitungsbausteine für die erfassten Parameter und die Modulation*/*Demodulation der Daten in Funksignale in dem Modul (3) integriert sind*

2. Installationsgerät nach Patentanspruch 1, **dadurch gekennzeichnet, dass** der Parameter der elektrische Strorn ist

3. Installationsgerät nach einem der vorhergehenden Patentansprüche, **dadurch gekennzeichnet, dass** der Parameter die elektrische Leistung ist.

4. Installationsgerät nach einem der vorhergehenden Patentansprüche, **dadurch gekennzeichnet, dass** ein an das Gerät (2) angeschlossener Verbraucher durch das Modul (3) abschaltbar ist.

5. Installationsgerät nach einem der vorhergehenden Patentansprüche, **dadurch gekennzeichnet, dass** Schwellwerte für die Abschaltung eines an das Gerät (2) angeschlossenen Verbrauchers in dem Modul (3) programmierbar sind

6. Installationsgerät nach einem der vorhergehenden Patentansprüche, **dadurch gekennzeichnet, dass** eine Ermittlung des Stromes berührungslos erfolgt.

7. Installationsgerät nach einem der vorhergehenden Patentansprüche, **dadurch gekennzeichnet, dass** die Übertragung von drahtlosen Signalen (14) mittels Funkwellen erfolgt.

8. Installationsgerät nach einem der vorhergehenden Patentansprüche, **dadurch gekennzeichnet, dass** die in dem Modul (3) eingehende Netzspannung transformiert wird.

9. Installationsgerät nach einem der vorhergehenden Patentansprüche, **dadurch gekennzeichnet, dass** das Modul (3) lösbar an dem Gerätesockel (6) des ersten Gerätes (2) angeordnet ist.

10. Installationsgerät nach einem der vorhergehenden Patentansprüche, **dadurch gekennzeichnet, dass** das Modul (3) frontseitig oder rückseitig des Gerätesockels (6) angeordnet ist.

11. Installationsgerät nach einem der vorhergehenden Patentansprüche, **dadurch gekennzeichnet, dass** der Gerätesockel (6) einen Aufnahmeraum (17) für ein formschlüssig einsteckbares Modul (3) aufweist.

12. Installationsgerät nach einem der vorhergehenden Patentansprüche, **dadurch gekennzeichnet, dass** das Modul (3) frontseitig und flächenbündig in dem Aufnahmeraum (17) des Gerätesockels (6) angeordnet ist.

13. Installationsgerät nach einem der vorhergehenden Patentansprüche, **dadurch gekennzeichnet, dass** bei der mechanischen Positivnierung des Moduls (3) an dem Gerätesockel (6) eine selbsttätige elektrische Kontaktierung erfolgt.

14. Installationsgerät nach einem der vorhergehenden Patentansprüche, **dadurch gekennzeichnet, dass** das erste Gerät (2) als elektrische Steckdose ausgeführt ist.

15. Gerätesystem für die Gebäudesystemtechnik, bestehend aus einem mehreren elektrischen Geräten (2, 12, 13), wobei ein erstes Gerät (2) gemäß den Patentansprüchen 1 bis 15 verwendet wird und wobei das Gerät (2) mit weiteren Geräten (12, 13) drahtlos kommuniziert.

16. Gerätesystem nach Patentanspruch 15, **dadurch gekennzeichnet,**
**dass** die Parameter an ein Gerät (12) drahtlos übermittelbar und in dem Gerät (12) visualisierbar sind.

17. Gerätesystem nach Patentanspruch 15 oder 16, **dadurch gekennzeichnet, dass** die Parameter an ein Gerät (12) drahtlos übermittelbar und von dem Gerät (12) aus regelbar sind.

18. Gerätesystem nach einem der Patentansprüche 15 bis 17, **dadurch gekennzeichnet, dass** das Gerät (12) eine Bedien- und Anzeigeeinheit (18) mit Bedienelementen und/oder variablen Anzeigemodi aufweist.

19. Gerätesystem nach einem der Patentansprüche 15 bis 18, **dadurch gekennzeichnet, dass** Schwellwerte für die Abschaltung eines an das Gerät (2) angeschlossenen Verbrauchers in dem Modul (3) und/oder dem Gerät (12) programmierbar sind.

## Claims

1. Installation device for building systems technology, having a device base (6) which is fastened in a stationary manner in an installation housing (4) and is connected to a mains voltage and to which a front element (8) is fastened on the front side, **characterized in that** a removable module (3) is arranged on the device base (6) in the installation housing (4) and can be used to record and/or control electrical parameters in the device (2) and which communicates wirelessly, processing modules for the recorded parameters and for modulating/demodulating the data into radio signals being integrated in the module (3).

2. Installation device according to Patent Claim 1, **characterized in that** the parameter is the electrical current.

3. Installation device according to one of the preceding patent claims, **characterized in that** the parameter is the electrical power.

4. Installation device according to one of the preceding patent claims, **characterized in that** a load connected to the device (2) can be disconnected by the module (3).

5. Installation device according to one of the preceding patent claims, **characterized in that** threshold values for disconnecting a load connected to the device (2) can be programmed in the module (3).

6. Installation device according to one of the preceding patent claims, **characterized in that** the current is contactlessly determined.

7. Installation device according to one of the preceding patent claims, **characterized in that** wireless signals (14) are transmitted by means of radio waves.

8. Installation device according to one of the preceding patent claims, **characterized in that** the mains voltage entering the module (3) is transformed.

9. Installation device according to one of the preceding patent claims, **characterized in that** the module (3) is detachably arranged on the device base (6) of the first device (2).

10. Installation device according to one of the preceding patent claims, **characterized in that** the module (3) is arranged on the front side or rear side of the device base (6).

11. Installation device according to one of the preceding patent claims, **characterized in that** the device base (6) has a receiving space (17) for a module (3) which can be inserted in a form-fitting manner.

12. Installation device according to one of the preceding patent claims, **characterized in that** the module (3) is arranged on the front side and in a flush manner in the receiving space (17) of the device base (6).

13. Installation device according to one of the preceding patent claims, **characterized in that** automatic electrical contact-connection is carried out when mechanically positioning the module (3) on the device base (6).

14. Installation device according to one of the preceding patent claims, **characterized in that** the first device (2) is in the form of an electrical socket.

15. Device system for building systems technology, consisting of a plurality of electrical devices (2, 12, 13), a first device (2) according to Patent Claims 1 to 15 being used, and the device (2) wirelessly communicating with further devices (12, 13).

16. Device system according to Patent Claim 15, **characterized in that** the parameters can be wirelessly transmitted to a device (12) and can be visualized in the device (12).

17. Device system according to Patent Claim 15 or 16, **characterized in that** the parameters can be wirelessly transmitted to a device (12) and can be controlled from the device (12).

18. Device system according to one of Patent Claims 15 to 17, **characterized in that** the device (12) has an operating and display unit (18) having operating elements and/or variable display modes.

19. Device system according to one of Patent Claims 15 to 18, **characterized in that** threshold values for disconnecting a load connected to the device (2) can be programmed in the module (3) and/or the device (12).

## Revendications

1. Appareil d'installation, destiné à la technique de systèmes du bâtiment, qui comporte un socle d'appareil (6) qui est fixé de manière stationnaire dans un boîtier d'installation (4) qui est raccordé sur une tension réseau et sur lequel est fixé sur la face frontale un élément frontal (8), **caractérisé en ce que** dans le boîtier d'installation (4), sur le socle d'appareil (6) est placé un module (3) détachable, à l'aide duquel des paramètres électriques dans l'appareil (2) peuvent être détectés et/ou réglés et qui communique sans fil, des blocs fonctionnels de traitement pour les paramètres détectés et la modulation/démodulation des données en signaux radio étant intégrés dans le module (3).

2. Appareil d'installation selon la revendication 1, **caractérisé en ce que** le paramètre est le courant électrique.

3. Appareil d'installation selon l'une quelconque des revendications précédentes, **caractérisé en ce que** le paramètre est la puissance électrique.

4. Appareil d'installation selon l'une quelconque des revendications précédentes, **caractérisé en ce qu'**un consommateur raccordé sur l'appareil (2) peut être mis à l'arrêt par le module (3).

5. Appareil d'installation selon l'une quelconque des revendications précédentes, **caractérisé en ce que** des valeurs seuils pour la mise à l'arrêt d'un consommateur raccordé sur l'appareil (2) sont programmables dans le module (3).

6. Appareil d'installation selon l'une quelconque des revendications précédentes, **caractérisé en ce que** qu'une détermination du courant s'effectue sans contact.

7. Appareil d'installation selon l'une quelconque des revendications précédentes, **caractérisé en ce que** la transmission de signaux (14) sans fil s'effectue via des ondes radioélectriques.

8. Appareil d'installation selon l'une quelconque des revendications précédentes, **caractérisé en ce que** la tension réseau entrant dans le module (3) est transformée.

9. Appareil d'installation selon l'une quelconque des revendications précédentes, **caractérisé en ce que** le module (3) est placé de manière amovible sur le socle d'appareil (6) du premier appareil (2).

10. Appareil d'installation selon l'une quelconque des revendications précédentes, **caractérisé en ce que** le module (3) est placé sur la face frontale ou sur la face arrière du socle d'appareil (6).

11. Appareil d'installation selon l'une quelconque des revendications précédentes, **caractérisé en ce que** le socle d'appareil (6) comporte un espace de logement (17) pour un module (3) insérable par complémentarité de forme.

12. Appareil d'installation selon l'une quelconque des revendications précédentes, **caractérisé en ce que** le module (3) est placé sur la face frontale et à fleur de surface dans l'espace de logement (17) du socle d'appareil (6).

13. Appareil d'installation selon l'une quelconque des revendications précédentes, **caractérisé en ce que** lors du positionnement mécanique du module (3) sur le socle d'appareil (6), il s'effectue une mise en contact électrique automatique.

14. Appareil d'installation selon l'une quelconque des revendications précédentes, **caractérisé en ce que** le premier appareil (2) est réalisé sous la forme d'une prise de courant électrique.

15. Système d'appareils pour la technique de systèmes du bâtiment, constitué d'un ou de plusieurs appareils (2, 12, 13) électriques, un premier appareil (2) selon les revendications 1 à 15 étant utilisé et l'appareil (2) communiquant sans fil avec des appareils (12, 13) supplémentaires.

16. Système d'appareils selon la revendication 15, **caractérisé en ce que** les paramètres peuvent être transmis sans fil à un appareil (12) et visualisés dans l'appareil (12).

17. Système d'appareils selon la revendication 15 ou la revendication 16, **caractérisé en ce que** les paramètres peuvent être transmis sans fil à un appareil (12) et réglés à partir de l'appareil (12).

18. Système d'appareils selon l'une quelconque des revendications 15 à 17, **caractérisé en ce que** l'appareil (12) comporte une unité de commande et d'affichage (18) avec des éléments de commande et/ou des modes d'affichage variables.

19. Système d'appareils selon l'une quelconque des revendications 15 à 18, **caractérisé en ce que** des valeurs seuils pour la mise à l'arrêt d'un consommateur raccordé sur l'appareil (2) sont programmables dans le module (3) et/ou l'appareil (12).
